# EUROPEAN PATENT APPLICATION

(11) **EP 1 204 298 A1**
(43) Date of publication of application: **08.05.2002**
(21) Application number: 00922963.4
(22) Date of filing: 02.05.2000
(51) Int. Cl.: H05B 3/20, H05B 3/56, H01L 21/30

(54) **CERAMIC HEATER**

(30) Priority: 09.08.1999 JP 22569599; 17.02.2000 WO PCT/JP00/00881
(71) Applicant: IBIDEN CO., LTD., Ogaki-shi Gifu-ken 503-0917 (JP)
(72) Inventor: ITO, Yasutaka, Ibiden Co., Ltd., Gifu 501-0695 (JP); HIRAMATSU, Yasuji, Ibiden Co., Ltd., Gifu 501-0695 (JP)
(74) Representative: Leson, Thomas Johannes Alois, Dipl.-Ing.
(86) International application number: JP0002909
(87) International publication number: WO0111922

(57) **Abstract**

The present invention has its object to provide a ceramic heater which has a high thermal conductivity so that the surface temperature of the heater plate promptly follows the temperature change of the heating element to control the temperature of the wafer-heating surface with high efficiency and the thermal diffusion of impurity from the ceramic heater can be successfully prevented.

This invention provides a ceramic heater comprising a nitride ceramic substrate and a heating element either on the surface or internally of said substrate

wherein said nitride ceramic board contains an element other than constituent elements of nitride ceramics and a work-heating surface has the JIS B 0601 surface roughness of Rmax = 0.2 to 200 µm.

## Description

### TECHNICAL FIELD

The present invention relates to a ceramic heater which finds application in semiconductor industry and does not contaminate semiconductor wafers.

### BACKGROUND ART

Semiconductor devices are manufactured through a process which comprises coating a photosensitive resin as an etching resist on a semiconductor wafer and etching the uncoated area.

While the photosensitive resin is applied in the form of a liquid to the surface of a semiconductor wafer by means of a spin coater or the like, it must be dried after coating to dissipate the solvent etc. and the thus-coated semiconductor wafer is set on a heater and heated.

The conventional metallic heater heretofore used for this purpose comprises a heating element disposed on the reverse side of an aluminum plate.

However, such a metallic heater has the following disadvantages.

First, because it comprises a metallic material, the heater plate must be as thick as about 15 mm. This is because a thin metal plate undergoes thermal expansion on the heating mode to develop a wrap and strains to damage or tip the semiconductor wafer placed on the plate. However, increasing the thickness of the heater plate leads to increases in heater weight and bulk.

Moreover, while the heater temperature is controlled by varying the voltage and current applied to the heating element, the great thickness of the metal plate causes the problem that the temperature of the heater plate cannot timely follow changes in voltage and current values, thus making temperature control difficult.

Therefore, Japanese Kokai Publication Hei-9-306642 and Japanese Kokai Publication Hei-4-324276, for instance, proposed ceramic heaters each comprising a substrate board comprising AIN, which is a non-oxide ceramic material of high thermal conductivity and high strength, and a heating element formed internally of said substrate board.

Regarding such ceramic heaters, ceramics containing Y, Na, B, Li, Rb and/or Ca are superior in thermal conductivity and, therefore, are preferred for use in heaters. JP 2798570, inter alia, discloses a sintered aluminum nitride material containing Ca and Na and having a high thermal conductivity.

Meanwhile, in the ordinary ceramic heater, as' described in Japanese Kokai Publication Hei-7-280462, the surface on which the heating element is formed is roughened while the surface on which a semiconductor wafer is to be placed and heated is flattened.

However, in a ceramic heater based on ceramics containing Y, Na, Ca and/or the like, if the surface on which a semiconductor wafer is to be placed is flat and smooth, the area of contact between the wafer and the ceramic heater is increased, with the result that the wafer is contaminated by thermal diffusion.

Moreover, even when the semiconductor wafer is not brought into direct contact with the heating surface of ceramic heater but held apart from the surface by means of support pins or the like and heated, the trouble of vaporized Y, Na, Ca, etc. being deposited on the semiconductor wafer is actually encountered.

A further disadvantage is that when a semiconductor wafer is held apart from the heating surface of the ceramic heater with supporting pins or the like and heated, the temperature distribution of the heating surface is reflected in the ceramic heater.

### SUMMARY OF THE INVENTION

The inventors of the present invention explored into the above problems with the prior art and found that by roughening the surface of a ceramic heater on which a wafer work such as a semiconductor wafer is placed or supported for heating (hereinafter referred to sometimes as the wafer-heating surface), the contact between the wafer-heating surface and the semiconductor wafer placed thereon can be made point contact, with the result that even when the ceramic board contains such impurities as Y and Na, the thermal diffusion of the impurities from the ceramic heater to the semiconductor wafer can be prevented. They further discovered that the vaporization of Y, Na, etc. from the wafer-heating surface can also be prevented by roughening said wafer-heating surface.

It was found that the failure of a semiconductor wafer to attain a uniform temperature when the semiconductor wafer is held apart from the heating surface during heating results from the turbulence of gas flow created in the clearance between the substrate, e.g. a semiconductor wafer, and the heating surface owing to the irregularities of said surface which cause a local accumulation of heat and further that the temperature distribution of the semiconductor wafer can be rendered more uniform by increasing the flatness of the heating surface to thereby preclude creation of said turbulence of gas flow. The inventors have accordingly perfected the present invention.

Thus, the ceramic heater according to the first aspect of the present invention comprises a ceramic substrate and a heating element disposed either on the surface or internally of said substrate, wherein the work-heating surface of the heater has a JIS B 0601 surface roughness of Rmax = 0.05 to 200 µm.

The ceramic heater according to the second aspect of the present invention comprises a ceramic substrate and a heating element disposed either on the surface or internally of said substrate, wherein said ceramic substrate contains an element other than its dominant constituent elements and the work-heating surface of the heater has a JIS B 0601 surface roughness of Rmax = 0.2 to 200 µm.

In the ceramic heaters according to said first and second aspects of the present invention, the ceramic substrate is preferably at least one member selected from the group consisting of a nitride ceramic, a carbide ceramic and an oxide ceramic.

The ceramic heater according to the third aspect of the present invention comprises a nitride ceramic substrate and a heating element disposed either on the surface or internally of said nitride ceramic substrate, wherein said nitride ceramic substrate contains an element other than its dominant constituent elements and the work-heating surface of the heater has a JIS B 0601 surface roughness of Rmax = 0.2 to 200 µm.

The ceramic heater according to the fourth aspect of the present invention comprises a nitride ceramic substrate and a heating element either on the surface or internally of said substrate, wherein said nitride ceramic substrate contains at least one additional element selected from the group consisting of Na, B, Y, Li, Rb and Ca and the heating surface thereof for heating a work has a JIS B 0601 surface roughness of Rmax = 0.2 to 200 µm.

In the ceramic heaters according to said third and fourth aspects of the present invention, the nitride ceramic substrate is preferably in the form of a disk having a diameter of more than 150 mm.

Furthermore, said ceramic substrate preferably contains not less than 0.1 weight % of at least one element selected from the group consisting of Y, Li, Rb and Ca and not less than 0.05 ppm of at least one element selected from the group consisting of Na and B.

### BRIEF DESCRIPTION OF THE DRAWINGS

Fig. 1 is a schematic plan view of a ceramic heater as an embodiment of the invention.
Fig. 2 is a schematic cross-section view showing a portion of the ceramic heater illustrated in Fig. 1.
Fig. 3 is a schematic cross-section view showing an electrostatic chuck according to the invention, which comprises a ceramic heater provided with static electrodes.
Fig. 4 is a cross-section view of the same electrostatic chuck as taken along the line A-A of Fig. 3.
Fig. 5 (a) to (d) are schematic cross-section views showing the flow of manufacture of said electrostatic chuck.
Fig. 6 is a schematic cross-section view, on partly exaggerated scale, of a part of the ceramic heater equipped with supporting pins.

### BRIEF DESCRIPTION OF NUMERIC SYMBOLS

- 10: ceramic heater
- 11: heater plate
- 11a: bottom face
- 11b: heating surface
- 12: heating element
- 12a: metal cover layer
- 13: external terminals
- 14: blind holes
- 15: through holes
- 16: support pin
- 19: semiconductor wafer
- 20,20a,20b: chuck positive electrode static layer
- 30,30a,30b: chuck negative electrode static layer
- 40: ceramic dielectric film
- 50: resistance heating element
- 90: silicon wafer
- 100: ceramic substrate
- 101: electrostatic chuck

### DETAILED DESCRIPTION OF THE INVENTION

The ceramic heater according to the first aspect of the present invention comprises a ceramic substrate and a heating element disposed either on the surface or internally of said substrate, wherein its work-heating surface has a JIS B 0601 surface roughness of Rmax = 0.05 to 200 µm.

The ceramic heater according to the second aspect of the present invention comprises a ceramic substrate and a heating element disposed either on the surface or internally of said substrate, wherein the ceramic substrate contains at least one additional element other than its dominant constituent elements and its work-heating surface has a JIS B 0601 surface roughness of Rmax = 0.2 to 200 µm.

The third and fourth aspects of the present invention are characterized by the defined raw material, heating surface roughness and elements in the ceramic substrate. Therefore, the following description is primarily directed to the first and second aspects of the invention and the other aspects of the invention will be additionally dealt with, where necessary.

The ceramic heater of the present invention is chiefly used for the heating of work-heating surface semiconductor wafers and the like, although it can be used for the purpose of heating other kinds of works as well.

Since the JIS B 0601 surface roughness of the ceramic heater according to the first aspect of the invention is Rmax = 0.05 to 200 µm, the work can be heated uniformly while it is held apart from its heating surface.

In the case of heating the work held apart from the heating surface, if the Rmax value of the heating surface exceeds 200 µm, a turbulence of gas flow is created between the work and the heating surface so that the heat is locally built up to cause a temperature distribution in the work. On the other hand, if the Rmax value is less than 0.05 µm, the temperature distribution of the heating surface is directly reflected on the work by radiant heat so that a temperature distribution is created. Thus, the range of Rmax = 0.05 to 200 µm is a characteristic range of surface roughness suited for the heating mode in which the work is held apart from the heating surface and heated in a gaseous heat transfer medium.

The gaseous heat transfer medium is preferably at least one species selected from among air, inert gases and reactive gases. The preferred inert gases are carbon dioxide gas, nitrogen gas and argon gas. As said reactive gases, halogen gases and CF₄ can be mentioned.

The preferred roughness Rmax of the heating surface is 0.2 to 100 µm. Within this range, the vaporization of impurities from the ceramic substrate can be successfully controlled.

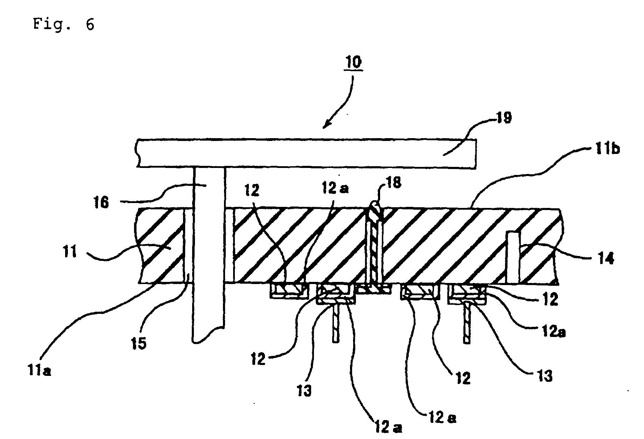

In order to hold the work apart from the heating surface, supporting pins 18 or the like are set securely in the through-holes or cavities of ceramic substrate 11 as shown in Fig. 6.

The preferred distance between the work and the heating surface is 1 to 5000 µm. If the distance is less than 1 µ m, the temperature distribution of the heating surface will be reflected on the work and, moreover, the undulation of the heating surface may cause mutual contact of the work and the heating surface. On the other hand, if the distance exceeds 5000 µm, the temperature difference between the heating surface and the work will become too large.

In the ceramic heater according to the second aspect of the present invention, the ceramic substrate contains an element other than its dominant constituent elements. However, since the roughness of the heating surface is set at Rmax = 0.2 to 200 µm, the work is protected against contamination by the thermal diffusion or evaporation of impurities from the ceramic substrate, particularly in the heating mode where the work is directly set on the heating surface and even in the heating mode where the work is heated while it is held apart at a given distance from the heating surface.

If the Rmax value of the heating surface is less than 0.2 µm, the area of contact between the heating surface and the work will be so large that said contamination with impurities diffusing into the work tends to take place. On the other hand, if the Rmax value exceeds 200 µm, the mean distance between the work and the heating surface will become too large to heat the work sufficiently.

Furthermore, even in the mode of heating the work held apart from the heating surface, the area of contact between the gaseous heat transfer medium and the heating surface is sufficiently large when the Rmax value is not less than 0.2 µm, so that the heat causative of evaporation of impurities from the surface of the ceramic substrate is effectively deprived of by said heat transfer medium, with the consequence that the work contamination is minimized.

Thus, the JIS B 0601 surface roughness of Rmax = 0.2 to 200 µm for the work-heating surface is a characteristic range in which the work can be successfully heated without contaminating the work.

The ceramics which can be used in the practice of the present invention includes nitride ceramics, carbide ceramics and oxide ceramics.

The preferred nitride ceramic is at least one member selected from among aluminum nitride, silicon nitride, boron nitride and titanium nitride.

Among these, aluminum nitride is the most preferred, for its thermal conductivity, 180 W/m·K, is the highest of all.

The preferred carbide ceramic is at least one member selected from among silicon carbide, titanium carbide, boron carbide, tantalum carbide, tungsten carbide and zirconium carbide.

The oxide ceramic is preferably at least one member selected from among alumina, silica, zirconia, mullite, cordierite and berrylia.

When the ceramic substrate is electrically conductive, an insulating layer may be provided on its surface adjacent to the heating element. The insulating layer is preferably made of SiO₂, Al₂O₃ or the like and the preferred thickness of this layer is 0.1 to 2000 µm.

When the heating element is a conductor wire, the surface of the conductor is covered with an insulating layer.

The particularly preferred ceramics are nitride ceramics and carbide ceramics, for these ceramics are high in thermal conductivity and, hence, superior in heat controllability. If the heat output of the heating element is not uniform, this uneven distribution of heat tends to be directly reflected on the heating surface when the thermal conductivity of the substrate material is high. Therefore, the effect of the surface roughness control according to the present invention can be exploited to advantage.

In the case of using the nitride ceramic as the ceramic substrate, said nitride ceramic board contains an element other than constituent elements of nitride ceramics, specifically at least one member selected from Y, Na, B, Li, Rb and Ca, and, as such, has good thermal conductivity, with the result that the surface temperature of the heater plate may timely follow the change in temperature of the heating element, thus enabling efficient control of the wafer-heating surface temperature.

Furthermore, since the wafer-heating surface has been roughened as mentioned above, the contact between the wafer-heating surface and the semiconductor wafer placed thereon can be made point contact so that the thermal diffusion of impurities (Y and other impurities) from the ceramic heater to the semiconductor wafer can be inhibited.

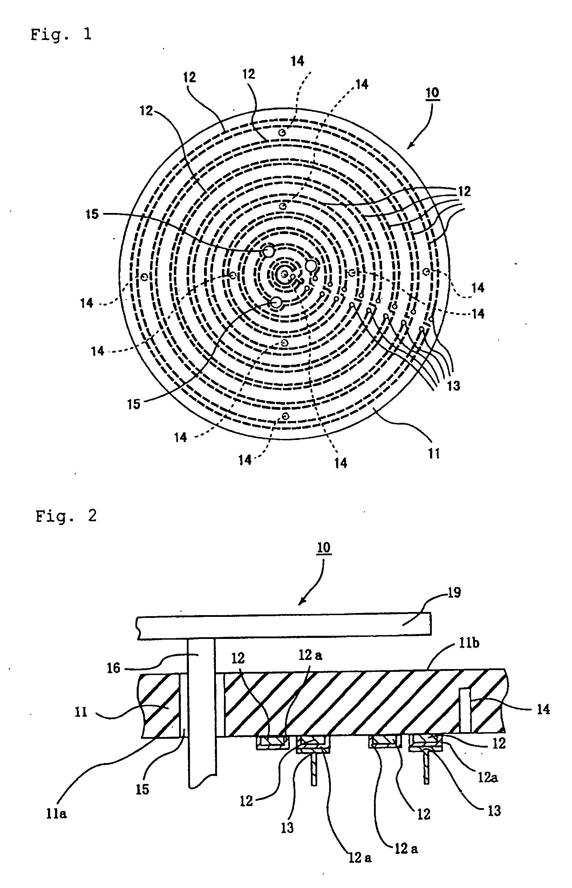

Moreover, even when a semiconductor wafer is supported out of contact by support pins as illustrated in Fig. 2, the impurity elements other than the constituent elements of nitride ceramics, such as Y, Na, B, Li, Rb, Ca, Al, etc. (hereinafter referred to as Y and other impurities) will diffuse out and become vaporized at an elevated temperature to contaminate the semiconductor wafer unless the wafer-heating surface is roughened. Particularly when the ceramic heater is used in a sputtering line, for instance, where the heating operation is carried out in a vacuum, Y and other impurities are more readily vaporized.

However, in the present invention wherein the wafer-heating surface has been roughened, Y and other impurities are not vaporized from the surface so that the contamination of the semiconductor wafer can be precluded.

It remains not to be fully known why the formation of a rough surface is effective in preventing vaporization of the elements other than the constituent elements of ceramics such as Y etc., but it is supposed that because the roughened wafer-heating surface has a function like the function of radiator fins and the surface is deprived of the heat causing vaporization of Y and other impurities.

When a semiconductor wafer is heated in the condition supported by support pins, the preferred distance between the semiconductor wafer and the ceramics is preferably 1 to 5000 µm, more preferably 5 to 500 µm. If they are too widely apart, the heating effect will be sacrificed, while an excessively close clearance results in a more or less faithful reflection of the surface temperature distribution of the ceramic board so that the semiconductor wafer cannot be uniformly heated.

The ceramic heater of the present invention comprises a heating element formed on the surface or internally of a nitride ceramic board.

Fig. 1 is a schematic plan view of a ceramic heater embodying the present invention and Fig. 2 is a sectional view showing a portion of the same heater on exaggerated scale.

A ceramic substrate 11 (hereinafter also referred to as a heater plate) is formed in the shape of a disk and a heating element 12 is formed in a pattern of concentric circles on the bottom side of the heater plate 11 so that the wafer-heating surface 11b of the nitride ceramic board (hereinafter referred to sometimes as heater plate) may be heated to a uniform temperature over its entire area. The heating element need not be a patterned element but may for example be a Peltier element.

The heating element 12 mentioned above actually comprises a plurality of concentric patterns of double-circles, each of said double-circles forming a single conductor and each of the patterns is connected, at both ends, to external terminals 13, one of which functions as an input terminal, with the other as an output terminal, each via a metal cover layer 12a. In addition, the heating element 12 is provided, near its center, with through holes 15 for accepting said support pins 16 adapted to support a semiconductor wafer and further with blind holes 14 for accepting temperature probes.

The ceramic heater 10 shown in Figs. 1 and 2 is provided with said heating element 12 on the bottom side of the heater plate 11. However, it may be formed internally of the heater plate 11.

The constituent members of the ceramic heater of the present invention are now described in further detail. In the following description, a nitride ceramic is taken as an example but the description applies to a carbide ceramic or an oxide ceramic as well.

In the ceramic heater 10 of the present invention, the heater plate 11 comprises nitride ceramics as the material of heater plate. This is because the particular material is lower than metal in the coefficient of thermal expansion and hence does not undergo curling or warping on heating even when its thickness is reduced, thus enabling reductions in both thickness and weight of the heater plate 11.

Furthermore, because of the high thermal conductivity and reduced thickness of the heater plate 11, the surface temperature of the heater plate 11 readily follows the temperature change of the heating element.

Stated differently, the temperature of the heating element can be adjusted by varying the voltage and current values to thereby control the surface temperature of the heater plate 11.

The heater plate 11 contains at least one element selected from Y, Na, B, Li, Rb and Ca.

Among them, Y, Li, Rb and Ca are generally added in the oxide form as sintering aids. In order that the thermal conductivity of the heater plate 11 may be as high as 130 to 200 W/m·K, the amount of Y, Li, Rb and/or Ca is preferably 0.1 to 5 weight %.

If the content of Y and other impurities is less than 0.1 weight %, no sufficient compaction will be attained in sintering, making it difficult to insure a high thermal conductivity.

Na and B are segregated in grain boundaries to contribute to an improved thermal conductivity.

The preferred amount of Na and B is 0.05 to 50 ppm. If the amount is less than 0.05 ppm, the thermal conductivity will not be enhanced.

These elements inherently occur in the starting material powder but, if necessary, a compound of Na and a compound of Ca, such as NaCO₃ and CaCO₃, may be added to the powder to bring their content into the above-mentioned range.

As the sintered aid for carbide ceramics, B₄C, AlN, etc. can be mentioned, and the impurities may for example be Al and B. The amount of Al and/or B in the ceramic substrate is 0.05 ppm to 0.5 weight %.

The heating surface of said heater plate 11 has been roughened to the JIS B 0601 surface roughness of Rmax = 0.05 to 200 µm for preventing a turbulence of heat transfer medium in the heating mode where the work is held apart from the heating surface during heating in the heat transfer medium.

In this mode where the work is held apart from the heating surface during heating, if the roughness of the heating surface is greater than Rmax = 200 µm, a turbulence of gas is created between the work and the heating surface and the consequent local accumulation of heat causes a temperature distribution in the work. On the other hand, if the surface roughness is less than Rmax = 0.05 µm, the temperature distribution of the heating surface will be directly reflected on the work by radiant heat, thus causing a temperature distribution in the work. The preferred surface roughness is Rmax = 0.2 to 100.

In the present invention, the heating surface of said heater plate 11 is roughened to a JIS B 0601 roughness of Rmax = 0.2 to 200 µm for the purpose of preventing diffusion of impurities into the semiconductor wafer.

If the surface roughness is less than Rmax = 0.2 µm, the mode of contact will be plane contact so that the diffusion of impurities into the semiconductor wafer may hardly be prevented. On the other hand, if the surface roughness exceeds Rmax = 200 µm, the wafer will not be sufficiently heated, not to speak of the difficulty of roughening, for probably because of the increased clearance between the wafer and the wafer-mounting surface, the amount of radiant heat or the heat propagated through the air and reaching the wafer is diminished.

Moreover, in the mode of use of the heater in which the wafer is supported by said support pins and heated without contacting, too, a heating surface with a degree of roughness less than Rmax = 0.2 µm is not effective in suppressing the vaporization of Y and other impurities. On the other hand, if the degree of surface roughness is over Rmax = 200 µm, the effective area of the heating surface will be increased to rather cause a greater amount of vaporization. Thus, the above Rmax range is effective in inhibiting the vaporization of Y and other impurities.

The preferred surface roughness is Rmax = 1 to 20 µm, for within this range, contact with the wafer does not easily give off dust particles.

The method for roughening the surface is not particularly restricted but may for example be the sand-blasting method in which alumina, SiC, glass, zirconia or other solid particles are blasted against the wafer-heating surface.

The preferred thickness of the heater plate 11 of the above ceramic heater is 0.5 to 5 mm. If the thickness is less than 0.5 mm, the plate will be liable to be destroyed because of reduced strength. On the other hand, if the thickness is larger than 5 mm, the conduction of heat will be poor so that the heating efficiency will be sacrificed.

In the ceramic heater of the present invention, the geometry of said nitride ceramic board is not particularly restricted. While it may for example be elliptical in plan view, a disk-shaped board such as the one illustrated in Fig. 1 is preferred. When the nitride ceramic board is disk-shaped, its diameter is preferably more than 150 mm, more preferably not less than 200 mm, and still more preferably not less than 300 mm. This is because semiconductor wafers in popular use today are not less than 8 inches (ca 200 mm) in diameter and it is expected that the majority of the next-generation semiconductor wafers will be still larger, i.e. 12 inches (300 mm) or more in diameter.

The heating element 12 formed on the surface or internally of said nitride ceramic board is preferably divided in at least two circuits. By dividing the circuitry, the amount of heat generation can be adjusted by controlling the power input to the respective component circuits, with the result that the temperature of the wafer-heating surface can be accordingly controlled.

The pattern of the heating element 12 may for example be a set of concentric circles, a vortex, a set of eccentric circles, or a serpentine form but the concentric pattern illustrated in Fig. 1 is preferred because it insures a uniform temperature distribution over the whole of the heater plate.

When the heating element 12 is to be formed on the surface of the heater plate 11, it is preferable to use the method which comprises coating the surface of the heater plate 11 with a conductive paste containing a metal powder in a predetermined circuit pattern and baking the resulting conductor paste layer to sinter the metal powder on the surface of the heater plate 11. It is sufficient that this sintering be effected to the extent of the metal particles being fused to each other and with the ceramics.

When the heating element is formed on the surface of the heater plate 11, the thickness of the heating element is preferably 1 to 30 µm, more preferably 1 to 10 µm. On the other hand, when the heating element is formed internally of the heater plate 11, its thickness is preferably 1 to 50 µm.

Moreover, when the heating element is formed on the surface of the heating element 11, the conductor width of the heating element is preferably 0.1 to 20 mm, more preferably 0.1 to 5 mm. When the heating element is formed internally of the heater plate 11, the conductor width of the heating element is 5 to 20 µm.

The resistance value of the heating element 12 can be freely adjusted by varying the conductor thickness and width but the above-mentioned ranges are most useful for practical purposes. The thinner and finer the width of the heating element is, the greater is its resistance value. The heating element 12 should be greater in thickness and width when it is formed internally of the heater plate 11. When the heating element 12 is formed internally, the distance between the heating surface and the heating element 12 is comparatively short, with the result that the temperature uniformity of the heating surface tends to be poor, thus making it necessary to increase the width of the heating element. Moreover, when the heating element 12 is to be disposed internally, its adhesion to nitride ceramics need not be taken into consideration, so that a high-melting metal such as tungsten or molybdenum or the carbide thereof can be used to increase the resistance and, therefore, the thickness itself can be increased for the purpose of preventing a disconnection trouble, for instance. From these considerations, the conductor thickness and width of the heating element 12 are preferably controlled within the above-mentioned ranges.

The heating element 12 may be rectangular or elliptic in section but preferably has a flat surface. The flat surface is more efficient in the radiation of heat toward the wafer-heating surface and is less liable to cause a temperature gradient.

The aspect ratio of the cross-section (width of heating element/thickness of heating element) is preferably 10 to 5000.

Because, by controlling said aspect ratio within this range, the resistance value of the heating element 12 can be increased and the temperature uniformity of the heating surface can be insured.

Assuming that the thickness of the heating element 12 is constant, the use of an aspect ratio smaller than the above range leads to a relatively reduced propagation of heat from the heater plate 11 in the wafer-heating direction so that a distribution of heat simulating the pattern of the heating element 12 is reproduced on the heating surface. Conversely, if the aspect ratio is too large, a relatively high temperature will prevail in the area immediately above the center of the heating element 12 so that a thermal distribution more or less simulating the pattern of the heating element 12 is likewise produced on the heating surface. Therefore, in consideration of temperature distribution, the aspect ratio of the cross-section is preferably confined to the range of 10 to 5000.

When the heating element 12 is to be formed on the surface of the heater plate 11, the aspect ratio is preferably 10 to 200 and when the heating element 12 is to be formed internally of the heater plate 11, the preferred aspect ratio is 200 to 5000.

That a larger aspect ratio is preferred when the heating element 12 is formed internally of the heater plate 11 is because, as the heating element 12 is internally disposed, the distance between the heating surface and the heating element 12 is relatively decreased so that the uniformity of surface temperature distribution is also reduced, thus requiring a more flat geometry for the heating element 12 as such.

When the heating element 12 is to be formed in an offset position within the heater plate 11, it is preferably formed in a position close to the surface (bottom surface) opposite to the heating surface of the heater plate 11 and within the range of 50% through 99% of the distance from the heating surface to said bottom surface.

If the amount of offset is less than 50%, the heating element 12 will be too close to the heating surface so that a temperature gradient tends to form on the heating surface. Conversely, if the amount of offset is over 99%, the heater plate 11 itself tends to wrap to destroy the semiconductor wafer.

Furthermore, when the heating element 12 is formed internally of the heater plate 11, the heating element may be divided in a plurality of layers. In this case, the patterns of the respective layers are preferably disposed in mutually complementary relation so that, when viewed from above the water-heating surface, the whole heating element 12 can be observed without overlaps over the entire field of view. Typical of such layout is a staggered arrangement of the patterns.

It is also allowable to form the heating element 12 internally of the heater plate 11, with the heating element 12 locally exposed.

The conductor paste is not particularly restricted but is preferably a composition containing not only the metal or conductive ceramic powder required for electrical conductivity but also a resin, a solvent, a thickener and other additives.

The metal powder mentioned above is preferably a powder of, for example, a noble metal (gold, silver, platinum, palladium), lead, tungsten, molybdenum or nickel. These metals can be used singly or in a combination of two or more species. Those metals are comparatively resistant to oxidation and have sufficiently high resistance to generate heat.

The conductive ceramic powder includes but is not limited to a powder of tungsten carbide or molybdenum carbide. Those powders can be used singly or in a combination of two or more species.

The preferred particle diameter of said metal or conductive ceramic powder is 0.1 to 100 µm. If the powder is finer than 0.1 µm, it will be ready to be oxidized. On the other hand, if the limit of 100 µm is exceeded, the powder will not be easily sintered and the resistance value will be increased.

The metal powder mentioned above may be spherical or flaky. A mixture of spherical and flaky powders may also be employed. When the metal powder is flaky or a mixture of spherical and flaky particles, the metal oxide added is held more effectively between the metal particles, with the consequent advantage that a firmer adhesion can be assured between the heating element 12 and the nitride ceramics and that the resistance value can be increased.

The resin for use in the conductor paste includes but is not limited to epoxy resin and phenolic resin. The solvent may for example be isopropyl alcohol. The thickener may for example be cellulose.

As mentioned above, the conductor paste is preferably prepared by adding metal oxides to the metal powder so that the heating element 12 will be a sintered body composed of the metal and metal oxide powders. Thus, by sintering the metal oxide together with the metal powder, an intimate bond can be realized between the heater plate nitride ceramics and the metal powder.

It remains to be fully clarified as yet why incorporation of the metal oxide results in an improved strength of bonding to the nitride ceramics but it may be suggested that since the surface of the metal particles and that of the nitride ceramics have been slightly oxidized and the resulting oxide films are integrally sintered together with the intermediary of the metal oxides added, thus causing an intimate adhesion of the metal powder to the nitride ceramics.

The metal oxide mentioned above is preferably at least one member selected from the group consisting of lead oxide, zinc oxide, silica, boron oxide (B₂O₃), alumina, yttria and titania.

These oxides are capable of improving the adhesion between the metal powder and nitride ceramics without increasing the resistance value of the heating element 12.

The proportions of said lead oxide, zinc oxide, silica, boron oxide (B₂O₃), alumina, yttria and titania in each 100 weight parts of the total metal oxide are 1 to 10 (weight parts; the same applies below) for lead oxide, 1 to 30 for silica, 5 to 50 for boron oxide, 20 to 70 for zinc oxide, 1 to 10 for alumina, 1 to 50 for yttria, and 1 to 50 for titania. The total of these oxides is preferably not more than 100 weight parts.

By adjusting the amount of the oxide within the above range, the bonding to nitride ceramics, in particular, can be improved.

The addition amount of said metal oxide relative to the metal powder is preferably not less than 0.1 weight % and less than 10 weight %. Moreover, the area resistivity of a heating element 12 formed with a conductor paste of the above composition is preferably 1 to 45 mΩ/□.

If the area resistivity exceeds 45 mΩ/□, the generation of heat will be too great in relation to the amount of voltage applied so that the amount of heat can hardly be controlled in the case of a heater plate carrying the heating element 12 on the surface. If the addition amount of said metal oxide is not less than 10 weight %, the area resistivity will exceed 50 mΩ/□ and the excessively increased heat generation will make temperature control difficult and the uniformity of temperature distribution will be sacrificed.

When the heating element 12 is formed on the surface of the heater plate 11, the surface of the heating element 12 is preferably provided with a metal cover layer 12a for preventing oxidation of the sintered metal and consequent change in resistance value. The thickness of the metal cover layer 12a thus formed is preferably 0.1 to 10 µm.

The metal for use in the formation of said metal cover layer 12a is not particularly restricted only provided that it is a non-oxidizable metal but may for example be gold, silver, palladium, platinum or nickel. These metals can be used alone or in a combination of two or more species. Among the metals mentioned above, nickel is particularly preferred.

While the heating element 12 must, of course, be provided with terminals for electrical connection to a power source and these terminals are attached to the heating element 12 via a solder, nickel is capable of inhibiting thermal diffusion of the solder. As the connecting terminal means, external terminals 13 comprising Koval®, for instance, can be used.

When the heating element 12 is formed internally of the heater plate 11, the surface of the heating element is not oxidized and, therefore, need not be covered. When the heating element 12 is formed internally of the heater plate 11, the heating element may be left partially exposed and provided with plated-through holes for accepting and securing in position said external terminals.

As the solder for use in connecting the external terminals 13, various alloys such as silver-lead, lead-tin, bismuth-tin, etc. can be used. The preferred thickness of the solder layer is 0.1 to 50 µm. Within this range, firm solder connections can be obtained.

Furthermore, as illustrated in Fig. 2, the heater plate 11 may be provided with through holes 15 so that, by inserting support pins (not shown) into the through holes 15, the semiconductor wafer may be delivered to a transfer machine (not shown) or received from such a machine.

The method of manufacturing the ceramic heater of the present invention is now described.

First, the process for fabrication of a ceramic heater comprising a heating element formed on the bottom surface of a heater plate 11 (Figs. 1 and 2) is described. In the following description, a nitride ceramic is taken as an example but the description applies to a carbide ceramic or an oxide ceramic as well.

### (1) Fabrication of a heater plate

The nitride ceramic powder described above, e.g. an aluminum nitride ceramic powder, is formulated with optional sintering aids, such as yttria (Y₂O₃), calcia (CaO), lithium oxide (Li₂O), rubidium oxide (Rb₂O), etc., compounds of Y, Na, Ca, Li, Rb and B, a binder and other components to prepare a slurry. This slurry is spray-dried to give granules, which are then placed in a metal mold or the like and compressed into a green board.

Then, the green board is optionally formed with through holes for accepting the support pins for supporting a semiconductor wafer and with blind holes in which temperature probes such as thermocouples are to be embedded.

Then, this green board is sintered by heating to provide a ceramic board. A heater plate 11 is then prepared by machining this ceramic board. As an alternative, the board may be formed to the specified size so that it may directly serve as a heater plate 11. By conducting a sintering operation under pressure, a cavity-free heater plate 11 can be fabricated. The heating temperature may be any temperature not below the sintering point but, in the case of nitride ceramics, a temperature within the range of 1000 to 2500 °C is used. Thereafter, at least the wafer-heating surface is roughened by sandblasting, for instance. If desired, both sides may be similarly roughened.

### (2) Printing the heater plate with a conductor paste

The conductor paste is generally a highly viscous fluid comprising a metal powder, a resin and a solvent. The conductor paste layer is formed by printing the board with said conductor paste in the pattern corresponding to a heating element by the screen printing technique, for instance. Since the heating element is required to heat the heater plate uniformly over the whole surface, it is preferably printed in a concentric circular pattern as illustrated in Fig. 1.

It is preferable that the conductor paste layer be formed in such a manner that the heating element 12 after sintering will present a rectangular section and a flat surface.

### (3) Baking the conductor paste

The conductor paste layer formed on the bottom surface of the heater plate 11 is then heated to remove the resin and solvent and bake the metal powder onto the bottom surface of the heater plate 11 to complete a heating element 12. The heating temperature is preferably 500 to 1000 °C.

When said metal oxide has been incorporated in the conductor paste, the metal powder, heater plate and metal oxide are integrally sintered to provide an improved bond between the heating element and heater plate.

### (4) Formation of a metal cover layer

The surface of the heating element 12 is preferably provided with the metal cover layer 12a. The metal cover layer 12a can be formed by, for example, electrolytic plating, electroless plating or sputtering but, for mass production, electroless plating is the most suitable of all.

### (5) Attaching terminals etc.

To ends of each circuit pattern of the heating element 12, terminals (external terminals 13) for electrical connection to a power source are attached by soldering. In addition, thermocouples are inserted and secured in the blind holes 14 with a silver or gold brazing material and sealed with a heat-resistant resin such as a polyimide resin to complete the manufacture of a ceramic heater.

The method of manufacturing a ceramic heater comprising a heating element 12 formed internally of a heater plate 11 is now described.

### (1) Fabrication of a heater plate

First, the nitride ceramic powder is mixed with the binder, solvent, etc. to prepare a paste, and using the paste, a green sheet is formed.

The nitride ceramic powder as mentioned above includes an aluminum nitride powder, and where necessary, sintering aids such as yttria as well as compounds of Na and Ca may be added.

The binder is preferably at least one member selected from the group consisting of acrylic binder, ethylcellulose, butylcellosolve and polyvinyl alcohol.

The solvent is preferably at least one member selected from the group consisting of α-terpineol and glycol.

The paste obtained by compounding those components is molded by the doctor blade method to provide said green sheet.

The preferred thickness of the green sheet is 0.1 to 5 mm.

Then, where necessary, the green sheet is formed with means to serve as through holes 15 for accepting support pins for supporting a semiconductor wafer, means to serve as blind holes in which temperature probes such as thermocouples are to be embedded, and means for serving as plated-through holes 18 for connecting the heating element to external terminal pins. This processing may be carried out after formation of a green sheet laminate to be described below or after sintering of the laminate.

### (2) Printing the green sheet with the conductive paste

On the green sheet, the conductive paste containing a metal or conductive ceramic powder is printed for the formation of a heating element.

The conductive paste contains a metal or conductive ceramic powder.

The mean particle diameter of tungsten or molybdenum powder is preferably 0.1 to 5 µm. If the mean particle diameter is less than 0.1 µm or over 5 µm, the printing of the conductive paste will be hardly curried out.

The conductive paste may for example be a composition (paste) comprising 85 to 87 weight parts of a metal or conductive ceramic powder, 1.5 to 10 weight parts of at least one kind of binder selected from the group consisting of acrylic binder, ethylcellulose, butylcellosolve and polyvinyl alcohol, and 1.5 to 10 weight parts of at least one kind of solvent selected from the group consisting of α-terpineol and glycol.

### (3) Laminating green sheets

The green sheets not printed with the conductive paste are laminated on both sides of the green sheet printed with'the conductive paste.

In this step, it is arranged so that the number of green sheets to be laminated on the top side is larger than the number of green sheets to be laminated on the bottom side so that the heating element will be situated offset in the direction of the bottom side.

Specifically, the preferred number of green sheets laminated is 20 to 50 on the top side and 5 to 20 on the bottom side.

### (4) Sintering the green sheet laminate

The green sheet laminate is hot-pressed to sinter the green sheets and the conductive paste within the laminate.

The heating temperature is preferably 1000 to 2000 °C and the pressure to be applied is preferably 100 to 200 kg/cm². The heating is performed in an inert gas atmosphere. The inert gas may for example be argon gas or nitrogen gas.

Then, roughening treatment is carried out by polishing at least one heating surface and, where necessary, further subjected to sand blasting or the like. This roughening treatment may be carried out on both sides.

The blind holes for accepting temperature probes may be formed after this sintering operation. The blind holes can be formed by blasting, e.g. sandblasting, after surface abrasion. In addition, external terminals 13 are connected to the plated-through holes for electrical connection to the internal heating element, followed by heating for reflow. The heating temperature is preferably 200 to 500 °C.

Then, thermocouples as temperature probes are embedded with the aid of a silver or gold brazing material and sealed with a heat-resistant resin such as a polyimide resin to complete the manufacture of a ceramic heater.

The operating temperature range of the heater of the present invention is 150 to 800 °C. As to the operating atmosphere, the heater can be used under atmospheric pressure or subatmospheric pressure. Under these conditions, the present invention expresses a particularly remarkable effect.

The ceramic heater of the present invention can be provided with static electrodes required for use as an electrostatic chuck, or with a chuck top surface conductor layer required for use as a wafer prover.

The construction of said electrostatic chuck is now briefly described.

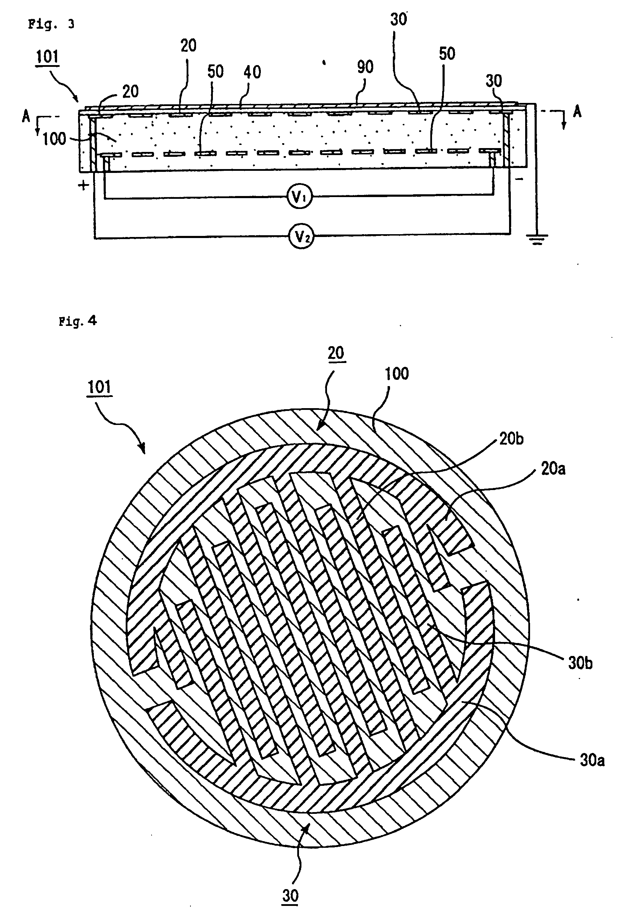

Fig. 3 is a schematic longitudinal section view showing the electrostatic chuck and Fig. 4 is a sectional view of the electrostatic chuck as taken along the line A-A of Fig. 3.

In this electrostatic chuck 101, a chuck positive and a chuck negative electrode layers 20, 30 are formed internally of an aluminum nitride board 100 and a ceramic dielectric film 40 further is formed. In addition, a resistance heating element 50 is formed internally of the aluminum nitride board 100 so that a silicon wafer 90 can be heated. Where necessary, the aluminum nitride board 100 may have a RF electrode embedded.

As illustrated in Fig. 4, the electrostatic chuck 101 is usually formed in a circular configuration in plan view, and as disposed internally of the aluminum nitride board 100, the chuck positive electrode static layer 20 comprising a semi-circular segment 20a and a comb-shaped segment 20b and the chuck negative electrode static layer 30 similarly comprising a semi-circular segment 30a and a comb-shaped segment 30b are arranged face-to-face in such a manner that the teeth of the two comb-shaped segments 20b, 30b are in staggered arrangement.

For operating this electrostatic chuck, the chuck positive and chuck negative electrode static layers 20 and 30 are connected to the + and - terminals, respectively, of a DC source and DC voltage is applied. Thereupon, the semiconductor wafer set on the electrostatic chuck is firmly attracted electrostatically.

### BEST MODE FOR CARRYING OUT THE INVENTION

The present invention is now described in further detail.

### (Example 1)

(1) A composition comprising 100 weight parts of aluminum nitride powder (manufactured by Tokuyama Co.; average particle diameter: 1.1 µm) containing Na and B in the concentrations of 0.1 ppm and 0.8 ppm, respectively, 4 weight parts of yttria (average particle diameter: 0.4 µm), 12 weight parts of acrylic binder and the remainder of alcohol was spray-dried to prepare a granular powder.
(2) This granular powder was set in a metal mold and formed into a green sheet. This green sheet was drilled to form openings corresponding to through holes 15 for accepting semiconductor wafer-support pins and openings corresponding to blind holes 14 for embedding thermocouples (1.1. mm dia. × 2 mm deep).
(3) The processed green sheet was then hot-pressed at 1800 °C and 200 kg/cm² to provide a 3 mm-thick aluminum nitride sheet.
   From this sheet, a disk having a diameter of 210 mm was cut out to provide a ceramic disk (heater plate 11).
   Both sides of this heater plate 11 were sandblasted with an alumina powder having an average particle size of 5 µm to form surface irregularities corresponding to Rmax = 6 µm according to JIS B 0601.
(4) On the heater plate 11 processed in (3) above, a conductor paste was applied by screen printing. The printing pattern was a concentric circular pattern as shown in Fig. 1.
   The conductor paste used was Solbest PS603D available from Tokuriki Kagaku Kenkyusho, which is in common use for the formation of plated-through holes in printed circuit boards.
   This conductor paste is a silver-lead paste containing, based on 100 weight parts of silver, 7.5 weight parts of metal oxide comprising lead oxide (5 wt. %), zinc oxide (55 wt. %), silica (10 wt. %), boron oxide (25 wt. %) and alumina (5 wt. %). The silver powder was a flaky powder having an average particle diameter of 4.5 µm.
(5) The heater plate 11 printed with the conductor paste as above was then heated at 780 °C to sinter the silver and lead in the conductor paste and bake them onto the heater plate 11 to form a heating element 12. The heating element composed of silver and lead was 5 µm thick × 2.4 mm wide and had an area resistivity of 7.7 mΩ/□.
(6) The heater plate 11 thus fabricated in (5) above was dipped in an electroless nickel plating bath comprising an aqueous solution of nickel sulfate 80 g/l, sodium hypophosphite 24 g/l, sodium acetate 12 g/l, boric acid 8 g/l and ammonium chloride 6 g/l to deposit a 1 µm-thick metal cover layer (nickel layer) 12a on the surface of the silver-lead heating element 12.
(7) The parts to which external terminals 13 are to be attached for electrical connection to a power source are printed with a silver-lead soldering paste (manufactured by Tanaka Noble Metals) by the screen printing technique to form a solder layer.
   On the solder layer, external terminals 13 of Koval® were placed, followed by heating for ref low at 420 °C. In this manner, the external terminals 13 were secured to the surface of the heating element 12.
(8) Thermocouples for temperature control were fixed in position with a 81.7 Au - 18.3 Ni gold brazing material (fusion by heating at 1030 °C) to provide a ceramic heater 10.

### (Comparative Example 1)

(1) Except that the prepared heater plate was not sandblasted to roughen both sides, the procedure of Example 1 was otherwise repeated to manufacture a ceramic heater. Because the roughening treatment was not performed, the surface roughness was Rmax = 0.1 µm according to JIS B 0601.

### (Comparative Example 2)

(1) Except that yttria was not added and Mitsui Toatsu's MAN-5 (Na and B at a concentration of less than 0.1 ppm) was used as the aluminum nitride powder in the fabrication of the heater plate, the procedure of Example 1 was otherwise repeated to manufacture a ceramic heater.

### (Comparative Example 3)

(1) After preparation of a heater plate, both sides of the plate were roughened by alumina (mean part. dia.: 250 µm) sandblasting to Rmax = 210 µm according to JIS B 0601.

### (Example 2)

A composition of 100 weight parts of aluminum nitride powder (manufactured by Tokuyama Co.; average particle diameter: 1.1 µm) containing Na and B in the concentrations of 0.1 ppm and 0.8 ppm, respectively, 5 weight parts of CaO (average particle diameter: 0.3 µm), 12 weight parts of acrylic binder and the remainder of alcohol was spray-dried to prepare a granular powder. Otherwise, the procedure of Example 1 was faithfully repeated to manufacture a ceramic heater.

### (Example 3)

A composition of 100 weight parts of aluminum nitride powder (manufactured by Tokuyama Co.; average particle diameter: 1.1 µm) containing Na and B in the concentrations of 0.1 ppm and 0.8 ppm, respectively, 3 weight parts of Li₂O (average particle diameter: 0.3 µm), 2 weight parts of Pb₂O (average particle diameter: 0.3 µm), 12 weight parts of acrylic binder and the remainder of alcohol was spray-dried to prepare a granular powder. Otherwise, the procedure of Example 1 was faithfully repeated to manufacture a ceramic heater.

Then, the surface of this heater plate 11 was polished with a 0.5 µm-diamond paste to Rmax = 0.8 µm and, thereafter, a ceramic heater was fabricated as in Example 1.

### (Example 4)

The procedure of Example 1 was substantially repeated. However, the external terminals were attached using a Ni-Au brazing material which was caused to reflow at 1030 °C. In addition, the surface was roughened by zirconia (mean part. dia. = 3 µm) sandblasting to Rmax = 4 µm according to JIS B 0601.

Furthermore, with the silicon wafer being supported with the support pins at a distance of 100 µm from the surface of the aluminum nitride ceramic board, heating under reduced pressure was performed up to 500 °C.

### (Example 5)

The procedure of Example 1 was substantially repeated. However, the external terminals were attached using a Ni-Au brazing material, which was caused to reflow at 1030 °C. In addition, the surface was roughened by zirconia (mean part. dia. = 15 µm) sandblasting to Rmax = 18 µm according to JIS B 0601.

Furthermore, with the wafer being supported with the support pins at a distance of 100 µm from the surface of the aluminum nitride ceramic board, heating under reduced pressure was performed up to 500 °C.

### (Example 6)

The procedure of Example 1 was substantially repeated. However, the external terminals were attached using a Ni-Au brazing material, which was caused to reflow at 1030 °C. In addition, the surface was roughened by zirconia (means part. dia. = 200 µm) sandblasting to Rmax = 180 µm according to JIS B 0601.

Furthermore, with the wafer being supported with the support pins at a distance of 100 µm from the surface of the aluminum nitride ceramic board, heating under reduced pressure was performed up to 500 °C.

### (Comparative Example 4)

The procedure of Example 1 was substantially repeated. However, the external terminals were attached using a Ni-Au brazing material, which was cause to reflow at 1030 °C. No sandblasting was carried out. Therefore, the surface roughness was Rmax = 0.1 µm.

Then, with the wafer being supported with the support pins at a distance of 100 µm from the surface of the aluminum nitride board, heating under reduced pressure was performed up to 500 °C.

### (Comparative Example 5)

The procedure of Example 1 was substantially repeated. However, the external terminals were attached using a Ni-Au brazing material, which was caused to reflow at 1030 °C. In addition, the surface was roughened by zirconia (means part. dia. = 250 µm) sandblasting to Rmax = 210 µm according to JIS B 0601.

Then, with the wafer being supported with the support pins at a distance of 100 µm from the surface of the aluminum nitride board, heating under reduced pressure was performed up to 500°C.

Using the ceramic heaters obtained above in Examples 1 to 6 and Comparative Examples 1 to 5, the Y, Na, Ca, Rb, Li and B contents were measured by fluorescent X-ray analysis and the thermal conductivity of each heater plate was measured by the laser flush method. In addition, a semiconductor wafer was set on each heater plate and heated to 500 °C and the diffusion of Y, Na, Ca, Rb, Li and B into the wafer was measured by fluorescent X-ray analysis. Moreover, the difference of temperature between the wafer surface and the wafer-heating surface was measured with the thermocouples.

The results are shown in Table 1.

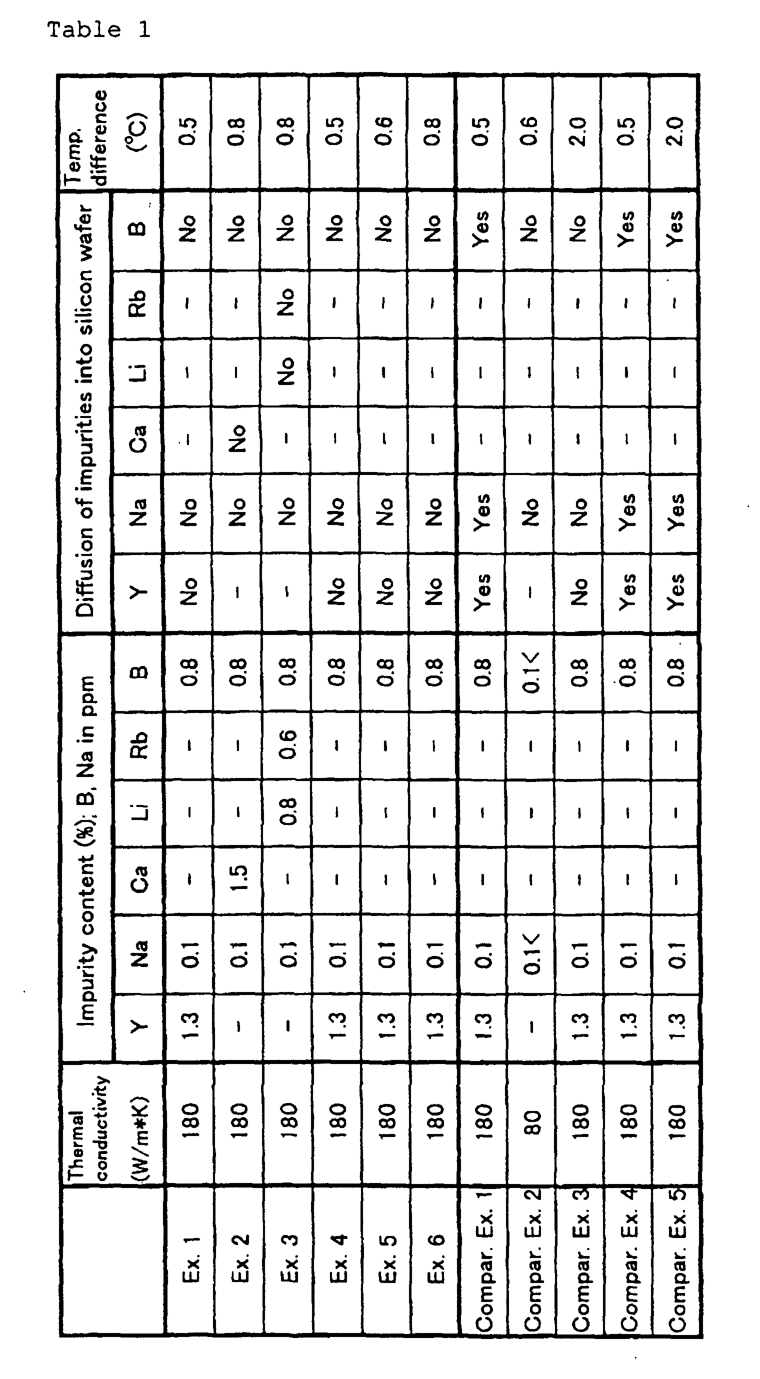

It will be apparent from the data in Table 1 that whereas the thermal conductivity of the heater plate was high and no diffusion of Y and other impurities was found with the ceramic heaters according to Examples 1 to 3, there occurred a diffusion of Y and other impurities into the wafer because of flatness of the wafer-heating surface of the ceramic heater in Comparative Example 1 and the thermal conductivity of the heater plate of the ceramic heater was low in Comparative Example 2 in which Y had not been added. Furthermore, in Comparative Example 3, the wafer was not sufficiently heated.

In Examples 4 to 6 where the semiconductor wafer was not directly set on the heating surface but held in suspension by support pins and followed by heating, no diffusion of Y and other impurities was observed. In contrast, contamination of the wafer with Y, Na or B was observed in Comparative Examples 4 and 5. This contamination was suspected to have been caused by vaporization of Y and other impurities.

### (Example 7) Manufacture of an electrostatic chuck

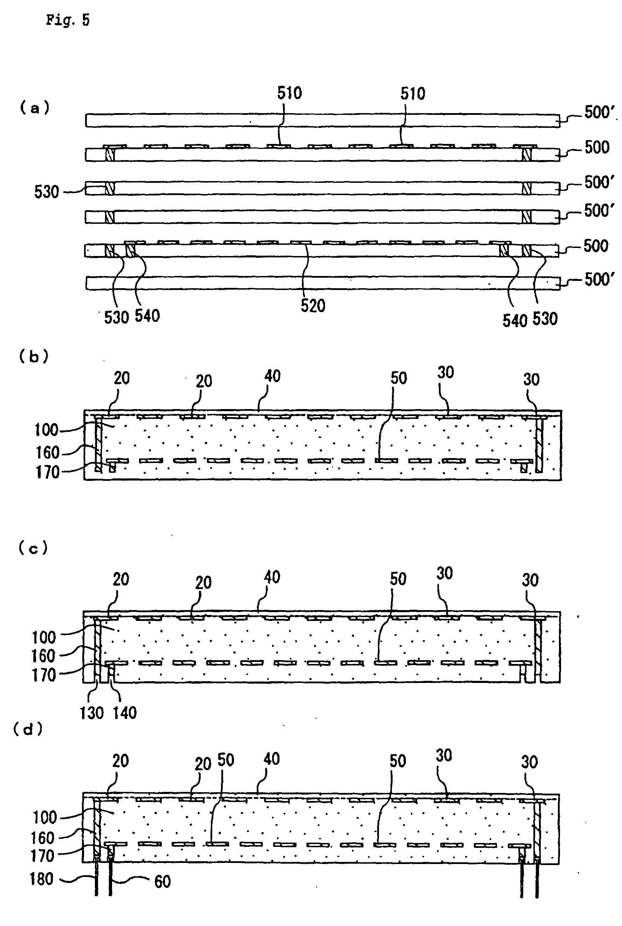

(1) Using a paste prepared by mixing 100 weight parts of aluminum nitride powder (manufactured by Tokuyama Co.; average particle diameter: 1.1 µm) containing Na and B in the concentrations of 0.1 ppm and 0.8 ppm, respectively, 4 weight parts of yttria (average particle diameter: 0.4 µm), 11.5 weight parts of acrylic binder, 0.5 weight part of dispersant and 53 weight parts of alcohol comprising 1-butanol and ethanol, a 0.47 mm-thick green sheet was molded by the doctor blade method.
(2) This green sheet was dried at 80 °C for 5 hours and formed with through holes to serve as the plated-through holes for electrical connection to external terminals by the punching method.
(3) A conductor paste A was prepared by mixing 100 weight parts of a tungsten carbide powder (1 µm in average particle size), 3.0 weight parts of acrylic binder, 3.5 weight parts of the solvent α-terpineol, and 0.3 weight part of dispersant.
   A conductor paste B was prepared by mixing 100 weight parts of a tungsten powder (3 µm in average particle size), 1.9 weight parts of acrylic binder, 3.7 weight parts of the solvent α-terpineol, and 0.2 weight part of dispersant.
   Using this conductive paste A, a conductor paste layer was formed on the green sheet by screen printing. The printing pattern was a concentric circular pattern. On another green sheet, a conductor paste layer was formed according to the static electrode pattern illustrated in Fig. 4.
   In addition, the through holes to serve as plated-through holes for connecting external terminals were filled with the conductor paste B. The static electrode pattern comprising comb-shaped electrodes 30 (20b, 30b), with 20b, 30b being connected to 20a and 30a, respectively.
   The green sheet 500 which had gone through the above processes was laminated with 34 and 13 units of green sheet 500' not printed with the tungsten paste on the top and bottom sides, respectively, and the green sheet 500 printed with the conductor paste in the static electrode pattern was further laminated thereon. In addition, 2 units of the green sheet 500' not printed with the tungsten paste were further laminated. The laminating temperature and pressure were 130 °C and 80 kg/cm² (Fig. 5 (a)).
(4) The above laminate was degreased in a nitrogen gas atmosphere at 600 °C for 5 hours and hot-pressed at 1890 °C and 150 kg/cm² for 3 hours to provide a 3 mm-thick aluminum nitride plate. From this plate, a disk 230 mm in diameter was cut out to provide an aluminum nitride disk internally provided with a 6 µm-thick × 10 mm-wide resistance heating element 50 and a chuck positive electrode static layer 20 and a chuck negative electrode static layer 30, both having a thickness of 6 µm (Fig. 5 (b)).
(5) The disk obtained in (4) was followed by abrasion with a diamond wheel, and with a mask set in position, its surface layer was formed with blind holes (diameter: 1.2 mm, depth: 2.0 mm) for accepting thermocouples by zirconia (mean part. dia. 1 µm) sandblasting.
   The surface roughness after sandblasting was Rmax = 2 µm.
(6) Then, the plated-through holes were bored to form cavities 130, 140 (Fig. 5 (c)) and external terminals 60, 180 comprising Koval® were connected and fixed in the cavities 130, 140 with a Ni-Au gold brazing material heated for reflow at 700 °C (Fig. 5 (d)).
   The connection of the external terminals is preferably a 3-point tungsten support system which is high in connection reliability.
(7) Then, a plurality of thermocouples for temperature control were embedded in the blind holes to complete the manufacture of an electrostatic chuck having a resistance heating element as illustrated in Fig. 3.
   A silicon wafer was set in position, and with a 1 kV electrode being applied for attraction of the wafer, the wafer was heated at 300 °C.
   In Example 7, a heater equipped with an electrostatic chuck was manufactured by providing static electrodes. Contamination of the wafer with Y and other impurities was not observed.

### (Example 8) Manufacture of a SiC ceramic heater

(1) A composition comprising 100 weight parts of SiC powder (mean particle diameter: 0.3 µm), 0.5 weight part of the sintered aid B₄C, 12 weight parts of acrylic binder and the balance of alcohol was spray-dried to prepare a granulation.
(2) This granulation was placed in a metal mold and molded into a flat plate form to give a green plate.
(3) This green plate was hot-pressed at 2100 °C and 180 kg/cm² to prepare a 3 mm-thick SiC plate.
   From the surface of this plate, a disk having a diameter of 210 mm was cut out for use as a ceramic substrate. The surface of this ceramic substrate was polished with a diamond paste having a grit diameter of 0.05 µm (Maruto) to prepare a heating surface with a roughness of Rmax = 0.08 µm.
   This SiC ceramic substrate was coated with a glass paste (Showei Kagaku Kogyo; G-5232N) and sintered at 1000 °C for 1 hour to form a 2 µm-thick SiO₂ film on the surface.
   This substrate was drilled to form a through-hole 15 for accepting a silicon wafer lifter pin and blind-holes 14 for embedding thermocouples (diameter: 1.1 mm × depth : 2 mm).
(4) The ceramic substrate obtained in the above Step (3) was printed with a conductor paste by the screen printing technique. The recipe of the conductor paste used was: 90 weight parts of silver scales (Showei Kagaku Kogyo; Ag-540), 10 weight parts of platinum needles (Showei Kagaku Kogyo; Pt-401), 7.5 weight parts of silica, 1.5 weight parts of boron oxide, 6 weight parts of zinc oxide, and 30 weight parts of the organic vehicle cellulose acetate.
(5) The ceramic substrate printed with the conductor paste in the above manner was then heated at 780 °C to sinter the silver and platinum in the conductor paste and bake them onto the ceramic substrate to provide a heating element. This heating element was 5 µm thick × 10 mm wide and had an area resistivity of 0.13 Ω/□.
(6) The surface of the heating element was coated with a glass paste (Showei Kagaku Kogyo; G-5177) and heated at 1000 °C to form a cover layer.
(7) To the parts of this heating element to which terminals for electrical connection to a power supply were to be attached, a silver brazing material was screen-printed to form a solder layer.
   Then, external terminals 13 of koval were set on the solder layer and the solder was caused to reflow by heating at 780 °C, whereby the external terminals 13 were rigidly secured to the surface of the heating element 12. The semiconductor supporting pins were also inserted and secured in position.
(8) Thermocouples for temperature control were fitted into the blind holes 14 and secured rigidly with a ceramic adhesive (Toa Gosei; Aron Ceramic) to complete a ceramic heater 10.

### (Example 9)

The procedure of Example 8 was repeated except that, after the polishing with a diamond paste having a grit diameter of 0.05 µm (Maruto), the substrate surface was subjected to sand blasting with an SiC powder having a mean particle diameter of 5 µm to form a rough surface of Rmax = 6 µm.

### (Example 10)

The procedure of Example 8 was repeated except that, after the polishing with a diamond paste having a grit diameter of 0.05 µm (Maruto), the substrate surface was subjected to sand blasting with an SiC powder having a mean particle diameter of 180 µm to form a rough surface of Rmax = 200 µm.

### (Comparative Example 6)

The procedure of Example 8 was repeated except that the substrate surface was polished with a diamond paste having a grit diameter of 0.01 µm (Maruto) to form a rough surface of Rmax = 0.03 µm.

### (Comparative Example 7)

The procedure of Example 8 was repeated except that, after the polishing with a diamond paste having a grit size of 0.05 µm (Maruto), the substrate surface was subjected to sand blasting with an SiC powder having a mean particle diameter of 250 µm to form a rough surface of Rmax = 210 µm.

### (Example 11)

### Manufacture of an aluminum nitride ceramic heater

(1) A composition comprising 100 weight parts of aluminum nitride powder (mean particle diameter: 0.6µm), 4 weight parts of yttria (mean particle diameter: 0.4 µm), 12 weight parts of acrylic binder and the balance of alcohol was spray-dried to prepare a granulation.
(2) This granulation was placed in a metal mold and molded in a flat sheet form to give a green plate.
(3) This green plate was hot-pressed at 1800 °C and 200 kg/cm² to prepare a 3 mm-thick aluminum nitride plate.
   From the surface of this plate, a disk having a diameter of 210 mm was cut out for use as a ceramic substrate 11. The same glass paste as used in Example 8 was coated on the surface of the above substrate and dried and sintered to form a 2 µm-thick SiO₂ film. Then, the surface of this ceramic substrate was polished with a diamond paste having a grit diameter of 0.05 µm (Maruto) to prepare a heating surface with a roughness of Rmax = 0.08 µm.
   This substrate was drilled to form a through-hole 35 for accepting a silicon wafer lifter pin and blind-holes 14 for embedding thermocouples (diameter: 1.1 mm × depth : 2 mm).
(4) A conductor paste was screen-printed on the ceramic substrate 11 obtained in the above step (3). The recipe of the conductor paste used was:
   50 weight parts of silver flakes (Showei Kagaku Kogyo; Ag-540), 50 weight parts of palladium spheres (Showei Kagaku Kogyo; Pd-225), 10 weight parts of zinc oxide, 8 weight parts of silica, 2 weight parts of boron oxide, and 30 weight parts of the organic vehicle cellulose acetate.
(5) The ceramic substrate 11 printed with the conductor paste in the above manner was then heated at 780 °C to sinter the silver and Pd in the conductor paste and bake them onto the ceramic substrate 11 to provide a heating element 12. This silver-Pd heating element 12 was 5 µm thick × 15 mm wide and had an area resistivity of 5.09 Ω/□.
(6) The surface of the heating element 12 was coated with a glass paste (Showei Kagaku Kogyo; G-5177) and heated at 1000 °C to form a cover layer.
(7) To the parts of this heating element to which terminals for electrical connection to a power supply were to be attached, a silver-lead solder paste was screen-printed to form a solder layer.
   Then, external terminals 13 of koval were set on the solder layer and the solder was caused to reflow by heating at 780 °C, whereby the external terminals 13 were rigidly secured to the surface of the heating element 12. The semiconductor supporting pins were also inserted and secured in position.
(8) Thermocouples for temperature control were fitted into the blind holes 14 and secured rigidly with a ceramic adhesive (Toa Gosei; Aron Ceramic) to complete a ceramic heater.

### (Example 12)

The procedure of Example 11 was repeated except that, after the polishing with a diamond paste having a grit diameter of 0.05 µm (Maruto), the substrate surface was subjected to sand blasting with an SiC powder having a mean particle diameter of 5 µm to form a rough surface of Rmax = 6 µm.

### (Example 13)

The procedure of Example 11 was repeated except that, after the polishing with a diamond paste having a grit diameter of 0.05 µm (Maruto), the substrate surface was subjected to sand blasting with an SiC powder having a mean particle diameter of 180 µm to form a rough surface of Rmax = 200 µm.

### (Comparative Example 8)

The procedure of Example 11 was repeated except that the surface of the substrate was polished with a diamond paste having a mean grit size of 0.01 µm (Maruto) to form a rough surface of Rmax = 0.03 µm.

### (Comparative Example 9)

The procedure of Example 11 was repeated except that, after the surface polishing with a diamond paste having a mean grit size of 0.05 µm, the substrate was subjected to sand blasting with zirconia having a mean grit size of 250 µm to form a rough surface of Rmax = 210 µm.

In each of Examples 8 to 13 and Comparative Examples 6 to 9, a silicon wafer was heated to 400 °C, with the distance between the heating surface of the ceramic heater and the silicon wafer being maintained at 100 µm and the difference ΔT between the highest and lowest temperatures of the silicon wafer was determined with Thermoviewer (Japan Datum; IR-16-2012-0012).

The results are shown below in Table 2.

**Table 2**

| | Surface roughness Rmax (µm) | Difference between highest and lowest temperatures ΔT (°C) |
|---|---|---|
| Example 8 | 0.08 | 4 |
| Example 9 | 6 | 3 |
| Example 10 | 180 | 4 |
| Example 11 | 0.08 | 5 |
| Example 12 | 6 | 4 |
| Example 13 | 180 | 5 |
| Compar. Ex. 6 | 0.03 | 8 |
| Compar. Ex. 7 | 210 | 8 |
| Compar. Ex. 8 | 0.03 | 10 |
| Compar. Ex. 9 | 180 | 10 |

It is apparent from Table 2 above that the temperature difference is large when the surface roughness Rmax is greater than 200 µm or smaller than 0.05 µm. This is probably because the temperature distribution of the heating surface is reflected in the silicon wafer when the surface roughness is too large or too small.

Incidentally, since SiC has a relatively higher heat conductivity (270 W/m·K), the temperature difference of the heating surface is smaller.

### INDUSTRIAL APPLICABILITY

In the ceramic heater of the present invention, the constitution of which has been described above, the heater element contains at least one element selected from among Y and others and, therefore, has a high thermal conductivity so that the surface temperature of the heater plate promptly follows the temperature change of the heating element to control the temperature of the wafer-heating surface with high efficiency.

Moreover, because the wafer-heating surface has been roughened, the mode of its contact with a semiconductor wafer is point contact so that the thermal diffusion of impurity from the ceramic heater into the semiconductor wafer can be successfully prevented and contamination of the semiconductor wafer etc. due to vaporization of the impurity is also prevented.

This heater can be applied to an electrostatic chuck and a wafer prover.

## Claims

1. A ceramic heater comprising a ceramic substrate and a heating element disposed either on the surface or internally of the substrate,
wherein the work-heating surface has a JIS B 0601 surface roughness of Rmax = 0.05 to 200 µm.

2. A ceramic heater comprising a ceramic substrate and a heating element disposed either on the surface or internally of the substrate,
wherein said ceramic substrate contains an element other than its dominant constituent elements and the work-heating surface of the heater has a JIS B 0601 surface roughness of Rmax = 0.2 to 200 µm.

3. The ceramic heater according to Claim 1 or 2
wherein said ceramic substrate is at least one member selected from among a nitride ceramic, a carbide ceramic and an oxide ceramic.

4. A ceramic heater comprising a nitride ceramic substrate and a heating element either on the surface or internally of said substrate,
wherein said nitride ceramic substrate contains an element other than its principal constituent elements and the work-heating surface of the heater has a JIS B 0601 surface roughness of Rmax = 0.2 to 200 µm.

5. A ceramic heater comprising a nitride ceramic substrate and a heating element either on the surface or internally of said substrate
wherein said nitride ceramic board contains at least one element selected from Na, B, Y, Li, Rb and Ca and a work-heating surface has a JIS B 0601 roughness value of Rmax = 0.2 to 200 µm.

6. The ceramic heater according to Claim 4 or 5
wherein said nitride ceramic board has the form of a disk having a diameter of more than 150 mm.

7. The ceramic heater according to Claim 4, 5 or 6
wherein the content of at least one element selected from the group consisting of Y, Li, Rb and Ca is not less than 0.1 weight %.

8. The ceramic heater according to Claim 4, 5 or 6
wherein the content of at least one element selected from the group consisting of Na and B is not less than 0.05 ppm.
